# EUROPEAN PATENT SPECIFICATION

(11) **EP 0 788 620 B1**
(45) Date of publication and mention of the grant of the patent: **11.11.1998**
(21) Application number: 95935274.1
(22) Date of filing: 12.10.1995
(51) Int. Cl.: G03F 7/022, G03F 7/004

(54) **POSITIVE PHOTOSENSITIVE COMPOSITION**
POSITIV ARBEITENDE LICHTEMPFINDLICHE ZUSAMMENSETZUNG
COMPOSITION PHOTOSENSIBLE POSITIVE

(30) Priority: 24.10.1994 US 327758; 22.05.1995 US 446261
(43) Date of publication of application: 13.08.1997
(73) Proprietor: Clariant Finance (BVI) Limited, Road Town, Tortola (VG)
(72) Inventor: RAHMAN, M., Dalil, Flemington, NJ 08822 (US); AUBIN, Daniel, P., Voluntown, CT 06384 (US)
(74) Representative: Hütter, Klaus, Dr.
(86) International application number: US9512719
(87) International publication number: WO9612988

(56) References cited:
- EP-A- 0 430 477
- EP-A- 0 468 531
- EP-A- 0 493 923
- EP-A- 0 504 724

## Description

### Field of the Invention

The present invention relates to positive photoresist compositions especially sensitive in the broad band range of the spectrum (365436 nm), based on a diazonaphthoquinone sensitizer using a compound of the following structure as a backbone, a novolak resin and a solvent. 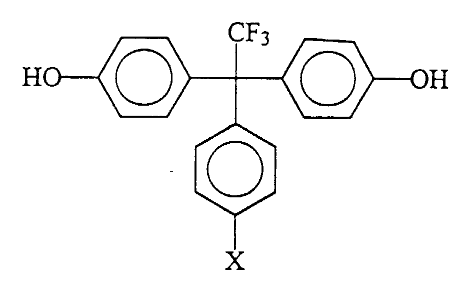 X = Cl, Br, I, OH, OR, COOR, COOAr(OH)ₙ,COAr(OH)ₙ, COR, R, Ar(OH)ₙ R = C₁-C₈ alkyl, n = 0 to 5, Ar = Phenyl

### Description of Related Art

Photoresists are materials which change their solubility in a developer solution after the photoresist has been exposed to actinic radiation, such as to ultra violet radiation. Photoresist compositions comprise a photosensitive compound (sometimes called a photosensitizer), a film forming polymeric resin and a solvent. There are other types of compositions possible, such as a photosensitizer composition dissolved in an appropriate solvent. The photoresist composition is applied to a substrate which is to be patterned and the solvent is then removed, as with heat, leaving the photoresist as a thin film covering the substrate. As a consequence of the exposure to radiation of the photoresist, a different solubility rate results between the exposed and unexposed (masked over) portions of the resist film which yields a surface relief pattern after development. Those photoresists which become more soluble in a developer solution in the exposed regions are referred to as "positive" photoresists. Those which become less soluble in the exposed regions are referred to as "negative" photoresists. The present invention deals with a class of those compounds suitable for use in positive photoresist compositions.

Positive photoresists may comprise an aqueous alkali soluble resin, such as a novolak resin or a poly(hydroxystyrene), and a photosensitizer. The resin and sensitizer are applied, such as by spin coating, spray coating, or other suitable means, from an organic solvent or solvent mixture onto a substrate, such as a silicon wafer or a chrome-plated glass plate. The developer used to process the positive photoresists are aqueous alkaline solutions, such as sodium metasilicate, potassium hydroxide, tetramethyl ammonium hydroxide and ammonium hydroxide. The developer removes the areas of the coated photoresist film that have been exposed to light or other form of irradiation so as to produce a relief pattern in the photoresist film.

The application of a photosensitive film to various substrates is an essential step in the fabrication of integrated circuits. The substrates are generally silicon wafers which may have a thin oxide coating or other coating such as silicon nitride or aluminum. The photosensitive film is used to pattern the substrate in a series of steps including exposure (through a mask pattern), development to yield a relief pattern in the resist layer and a substrate etch step to transfer that pattern into the substrate material. It is essential that the mask pattern be accurately reproduced in the substrate etch pattern. To achieve this high degree of accuracy, the mask pattern must be well resolved by the photoresist layer. Conventional photoresists may employ novolak resins as the alkali soluble, film forming polymer.

### Background of the Invention

The present invention relates to radiation sensitive positive working photoresist compositions and particularly to compositions containing novolak resins together with a photosensitizer which is a diazo sulfonyl diester produced by reacting 2,1,4 or 2,1,5 diazo sulfonyl chloride with the following structure as a backbone: 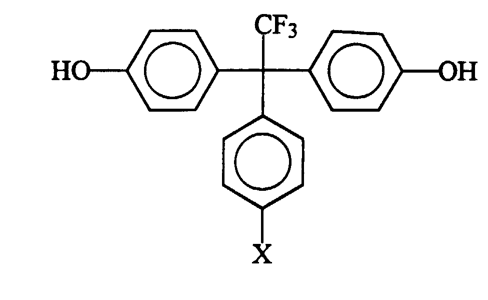 X = Cl, Br, I, OH, OR, COOR, COOAr(OH)ₙ,COAr(OH)ₙ, COR, R, Ar(OH)ₙ R = C₁-C₈ alkyl, n = 0 to 5, Ar = Phenyl

It is known to the skilled artisan to produce positive photoresist compositions such as those described in United States Patent Nos. 3,666,473; 4,115,128 and 4,173,470. These include water insoluble, aqueous alkali-soluble phenol-formaldehyde novolak resins together with light-sensitive materials, usually a substituted naphthoquinone diazide compound. The resins and sensitizers are dissolved in an organic solvent or mixture of solvents and are applied as a thin film or coating to a substrate suitable for the particular application desired.

The novolak resin component of these photoresist formulations is soluble in aqueous alkaline solutions, but the sensitizer is not soluble prior to exposure. Upon imagewise exposure of portions of the coated substrate to actinic radiation, the sensitizer is rendered alkali soluble and the exposed areas of the coating become more soluble than the unexposed areas. This difference in solubility rates causes the exposed areas of the photoresist coating to be dissolved when the substrate is immersed in or otherwise contacted with an alkaline developing solution, while the unexposed areas are largely unaffected, thus producing a positive relief pattern on the substrate. The exposed and developed substrate is usually thereafter subjected to an etching process. The photoresist coating protects the coated areas of the substrate from the etchant and the etchant is only able to etch the uncoated areas of the substrate, which correspond to the areas that were exposed to actinic radiation. Thus, an etched pattern can be created on the substrate which corresponds to the pattern of the mask, stencil, template, etc., that was used to created selective exposure patterns on the coated substrate prior to development. The relief pattern of photoresist on a substrate produced by this method is useful for various applications including the manufacture of miniaturized integrated circuits.

The characteristics of the photoresist compositions, which are important in commercial practice, include its photospeed, contrast, resolution (edge acuity), thermal stability of the image during processing, processing latitude, line width control, clean development and unexposed film loss.

Photoresist contrast is the slope of the linear portion of the curve resulting from the plot of the log of exposure energy vs. normalized film thickness remaining under fixed development conditions. In use, development of an exposed resist coated substrate is continued until the coating on the exposed area is substantially completely dissolved away. Resolution refers to the capability of a resist system to reproduce the smallest equally spaced line pairs and intervening spaces of a mask which is utilized during exposure with a high degree of image edge acuity in the developed exposed spaces. In the manufacture of miniaturized electronic components, a photoresist is required to provide a high degree of resolution for very small line and space widths usually on the order of one micron or less. This capability to reproduce very small dimensions, is extremely important in the production of large scale integrated circuits on silicon chips and similar components. Circuit density on such a chip can only be increased, assuming photolithography techniques are utilized, by increasing the resolution capabilities of the resist. Although negative photoresists, wherein the exposed areas of resist coating become insoluble and the unexposed areas are dissolved away by the developer, have been extensively used for this purpose by the semiconductor industry, positive photoresists have inherently higher resolution and are utilized as replacements for the negative resists.

In photoresist technology, it has normally been desired to increase resist contrast. High contrast positive working resists produce developed images which exhibit high edge acuity, when exposure is performed on typical equipment such as steppers and projection aligners. In most lithographic semiconductor applications, the high edge acuity of developed images is of great importance since it allows for small variations of line width over the wafer's topography. Therefore, it permits good control of etching during anisotropic plasma-etching and is typically associated with good processing latitude.

### Summary of the Invention

The invention provides a new photosensitizer and new positive photoresist compositions containing this photosensitizer. Such photoresist compositions have good photospeed, high contrast, good resolution, good thermal stability of the image during processing, wide processing latitude, good line width control, clean development and low unexposed film loss.

The photosensitive compound of the present invention comprises: a diazo sulfonyl ester of a compound having the following structure as a backbone: 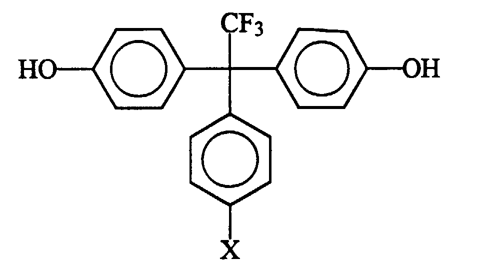 X = Cl, Br, I, OH, OR, COOR, COOAr(OH)ₙ,COAr(OH)ₙ, COR, R, Ar(OH)ₙ R = C₁-C₈ alkyl, n = 0 to 5, Ar = Phenyl
wherein the diazo ester is a compound wherein at least one hydroxy group on the Phenylring has been esterified with a diazosulfonyl chloride. On average, from 60 mole percent to 100 mole percent of the hydroxy groups of the above structure have been esterified by the diazosulfonyl chloride. The diazo ester moiety is from 60 to 100 mole percent 2,1,4-diazo sulfonyl chloride or 2,1,5-diazo sulfonyl chloride, or a mixture thereof. Preferably the diazo ester distribution ranges from 75 to 100 mole percent and most preferably from 85 to 95 mole percent.

The invention also provides a method for producing a positive photoresist composition, which comprises providing an admixture of:
(a) a photosensitive component containing a diazo sulfonyl ester of a compound having the following structure as a backbone: 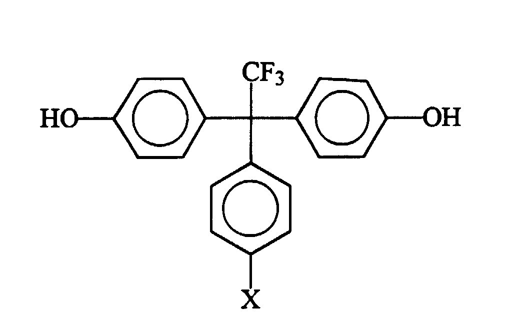 X = Cl, Br, I, OH, OR, COOR, COOAr(OH)ₙ,COAr(OH)ₙ, COR, R, Ar(OH)ₙ R = C₁-C₈ alkyl, n = 0 to 5, Ar = Phenyl
   wherein the diazo ester is a compound wherein at least one hydroxy group on the Phenylring has been esterified with a diazosulfonyl chloride; on average, from about 60 mole percent to about 100 mole percent of the hydroxy groups of the above structure type molecule have been esterified by one diazosulfonyl chloride, the photosensitive component being present in the photoresist composition in an amount sufficient to uniformly photosensitize the photoresist composition; the diazo moiety ester is from 60 to 100 mole percent 2,1,4 or 2,1,5 diazo ester or mixture thereof; preferably the diazo ester distribution range from 75 to 100 mole percent and most preferably from 85 to 95 mole percent;
(b) a water insoluble, aqueous alkali soluble novolak resin; the novolak resin being present in the photoresist composition in an amount sufficient to form a substantially uniform photoresist composition; and
(c) a suitable solvent, preferably propylene glycol methyl ether acetate (PGMEA), 2-heptanone, ethyl lactate, ethyl 3-ethoxy propionate (EEP) or a mixture thereof.

A method is provided for producing a photoresist image on a substrate by providing an admixture of:
(a) a photosensitive component containing a diazo sulfonyl ester of a compound having the following structure as a backbone: 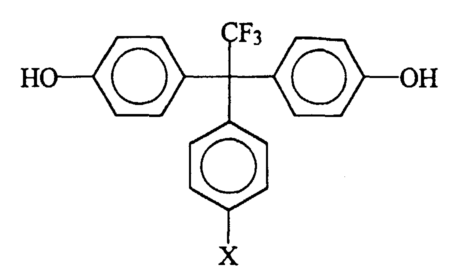 X = Cl, Br, I, OH, OR, COOR, COOAr(OH)ₙ,COAr(OH)ₙ, COR, R, Ar(OH)ₙ R = C₁-C₈ alkyl, n = 0 to 5, Ar = Phenyl
   the diazo ester is a compound wherein at least one hydroxy group on the phenylring has been esterified with a diazosulfonyl chloride; on average, from about 60 mole percent to about 100 mole percent of the hydroxy groups of the above structure type molecule have been esterified by the diazosulfonyl chloride; the photosensitive component being present in the photoresist composition in an amount sufficient to uniformly photosensitize the photoresist composition; the diazo ester moiety is from 60 to 100 mole percent of 2,1,4-diazo sulfonyl chloride or 2,1,5-diazo sulfonyl chloride, or a mixture thereof; preferably the diazo ester distribution range from 75 to 100 mole percent and most preferably from 85 to 95 mole percent;
(b) a water insoluble, aqueous alkali soluble novolak resin; the novolak resin being present in the photoresist composition in an amount sufficient to form a substantially uniform photoresist composition; and
(c) a suitable solvent, such as propylene glycol methyl ether acetate (PGMEA), ethyl lactate, ethyl 3-ethoxy propionate (EEP) or a mixture of two or more thereof, and thereby producing a photoresist;
coating the photoresist of (c) onto substrate; heat treating the coated substrate until substantially all of the solvent composition is removed; imagewise exposing the photosensitive composition to actinic radiation; and removing the image-wise exposed areas of the composition with an aqueous alkaline developer (optionally, one may perform a baking of the substrate either immediately before or after the removing step).

The coating solvents may be present in the overall composition in an amount of up to 95% by weight of the solids in the composition. Solvents, of course are substantially removed after coating of the photoresist solution on a substrate and drying. Non-ionic surfactants that may be used include, for example, nonylphenoxy poly(ethyleneoxy) ethanol; octylphenoxy ethanol at up to 10% weight levels, based on the combined weight of novolak and sensitizer.

The prepared resist solution, can be applied to a substrate by any conventional method used in the photoresist art, including dipping, spraying, whirling and spin coating. When spin coating, for example, the resist solution can be adjusted with respect to the percentage of solids content in order to provide coating of the desired thickness given the type of spinning equipment utilized and the amount of time allowed for the spinning process. Suitable substrates include silicon, aluminum, polymeric resins, silicon dioxide, doped silicon dioxide, silicon nitride, tantalum, copper, polysilicon, ceramics, aluminum/copper mixtures; gallium arsenide and other such Group III/V compounds. The photoresist coatings produced by the above described procedure are particularly suitable for application to thermally grown silicon/silicon dioxide-coated wafers such as are utilized in the production of microprocessors and other miniaturized integrated circuit components. An aluminum/aluminum oxide wafer can be used as well. The substrate may also comprise various polymeric resins especially transparent polymers such as polyesters. The substrate may have an adhesion promoted layer of a suitable composition such as one containing hexa-alkyl disilazane.

The resist composition solution is then coated onto the substrate, and the substrate is heat treated at from 80°C to 110°C for from 30 to 180 seconds on a hot plate or for from 15 to 40 minutes in a convection oven. This temperature treatment is selected in order to reduce the concentration of residual solvents in the photoresist while not causing substantial thermal degradation of the photosensitizer. In general one desires to minimize the concentration of solvents and thus this first temperature treatment is conducted until substantially all of the solvents have evaporated and a thin coating of photoresist composition, on the order of a micron in thickness, remains on the substrate. In a preferred embodiment the heat treatment is conducted at from 85°C to 95°C. The treatment is conducted until the rate of change of solvent removal becomes relatively insignificant. The temperature and time selection depends on the resist properties desired by the user as well as equipment used and commercially desired coating times. The coating substrate can then be exposed to actinic radiation, especially ultraviolet radiation, at a wavelength of from 300 nm to 450 nm (preferably at 365 nm), x-ray, electron beam, ion beam or laser radiation, in any desired pattern, produced by use of suitable masks, negatives, stencils and templates,

The resist is then optionally subjected to a post exposure second baking or heat treatment, either before or after development. The heating temperatures may range from 90°C to 50°C, more preferably from 110°C to 150°C. The heating may be conducted for from 10 seconds to 30 minutes, more preferably from 45 seconds to 90 seconds on a hot plate or 10 to 30 minutes by convection oven.

The exposed resist-coated substrates are developed to remove the imagewise exposed, non-image areas by spray developing using an alkaline developing solution. The solution is preferably agitated, for example, by nitrogen burst agitation. The substrates are allowed to remain in the developer until all, or substantially all, of the resist coating has dissolved from the exposed areas. Developers may include aqueous solutions of ammonium or alkali metal hydroxides. One preferred hydroxide is tetramethyl ammonium hydroxide (TMAH). A suitable developer is AZ® Developer available commercially from the AZ Photoresist Products group of Hoechst Celanese Corporation, Somerville, New Jersey. After removal of the coated wafers from the developing solution, one may conduct an optional post-development heat treatment or bake to increase the coating's adhesion and chemical resistance to etching solutions and other substances. The post-development heat treatment can comprise the oven baking of the coating and substrate below the coating's softening point. In industrial applications, particularly in the manufacture of microcircuitry units on silicon/silicon dioxide-type substrates, the developed substrates may be treated with a buffered, hydrofluoric acid base etching solution. The resist compositions of the present invention are resistant to acid-base etching solutions and provide effective protection for the unexposed resist-coating areas of the substrate.

The following specific examples will provide detailed illustrations of the methods of producing and utilizing the compositions of the present invention. These examples are not intended to limit or restrict the scope of the invention in any way and should not be construed as providing conditions, parameters or values which must be utilized exclusively in order to practice the present invention.

### EXAMPLE 1

### Synthesis of 2,1,5-and 2,1,4-Diazo Ester of 1,1-Bis(4-hydroxyphenyl)-1-(4-bromophenyl)-2,2,2,-trifluro ethane

Into a 200 ml., four necked flask equipped with a thermometer, stirring shaft and dropping funnel were added 5.0 grams (.01182moles) of 1,1-Bis(4-hydroxyphenyl)-1-(4-bromophenyl)-2,2,2,-trifluro ethane and 4.73 grams (.01761 moles) of 2,1,5-diazo sulfonyl chloride and 2.03 grams (0.00765 moles) of 2,1,4-diazo sulfonyl chloride and 18 ml. of gamma- Butyrolactone (BLO) and 10 ml of acetone. The mixture was stirred at room temperature (25°C) for about 30 minutes to obtain a clear solution.

A separate solution of 4.52 grams (.0403 moles) of 1,4 - diazobicyclo (2.2.2) octane in 17 ml of BLO and 8 ml of acetone was added into the reaction flask by using a dropping funnel over a period of 10 minutes while maintaining the temperature at 30°C. The reaction mixture was stirred for 1 hour at room temperature. After the reaction was complete, 2 ml. of glacial acetic acid was added to destroy any unreacted sulfonyl chloride. The reaction mixture was stirred for one hour and then filtered to remove salt and any impurities.

The reaction mixture was precipitated by drowning into a mixture of 220 ml. deionized water and 20 ml. of methanol. A yellow fine precipitate was obtained, which was stirred for several hours then decanted, filtered and washed with about 3 liters of deionized water. The yellow cake was air dried first at room temperature by drawing air through a buchner funnel. When the cake was air dried, it was placed in a vacuum oven at 35°C overnight. HPLC data indicated ester distribution to be: 2,1,4/2,1,5 (F/L) Bis Ester 47.25%; 2,1,5/2,1,5-(L/L) Bis Ester 22.02%; 2,1,4/2,1,4 (F/F) Bis Ester 27.11% and Unreacted 2,1,4-diazo Acid/Other Esters 2-4%.

### EXAMPLE 2

### Lithographic Evaluation of 2,1,4- and 2,1,4-Diazo Ester of 1,1 -Bis(4-hydroxyphenyl)-1-(4-bromophenyl)-2,2,2,-trifluro ethane (from Example 1):

A formulation of 1,1-Bis(4-hydroxyphenyl)-1-(4-bromophenyl)-2,2,2,-trifluro ethane diazo ester (PAC) was prepared by mixing with a 26% solution of a m-cresol/3,5-xylenol (5:3 ratio) Novolak resin (NR) in PGMEA. The formulations were spin coated on silicon wafers at 4000 RPM to obtain 1-1.2 micron film thickness. The wafers were soft baked in an air oven at 90°C for 30 minutes. All wafers were developed using 0.263n TMAH developer at 25+/-0.5°C. The following parameters were evaluated:

| Example | % PAC | RO | R | R/RO | Photospeed (mj/cm²) |
|---|---|---|---|---|---|
| #2 | 12.0 | 12 | 44256 | 3688 | 130 |
| RO = Dark Film Loss | | | | | |
| R = Dissolution Rate of Fully Bleached Film | | | | | |
| PAC = 2,1,4-Diazo Ester of Phenolphthalein | | | | | |

High R/RO values indicate greatest differential between exposed and unexposed film loss which affects photospeed and contrast. In comparison to conventional Diazo esters R/RO values are higher for phenolphthalein Diazo esters.

RESOLUTION: Using the formulation of Example 2, 0.5 micron line and space patterns were printed. The dose required to print 0.5 micron geometry using 1.0 micron thick film was 170 mj/cm². The wall profile was nearly vertical and there was no scum at the surface of the film.

## Claims

1. A positive photoresist composition comprising an admixture of:
(a) a photosensitizer comprising a diazo ester having the following structure: 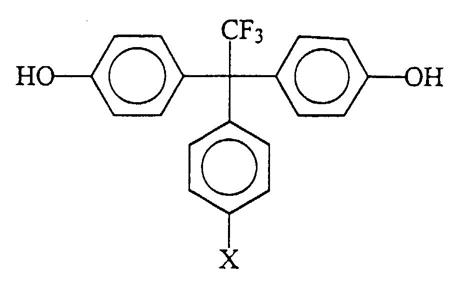 X = Cl, Br, I, OH, OR, COOR, COOAr(OH)ₙ,COAr(OH)ₙ, COR, R, Ar(OH)ₙ R = C₁-C₈ alkyl, n = 0 to 5, Ar = Phenyl
as the backbone, where the diazo ester is a compound wherein at least one hydroxy group on the phenyl ring has been esterified with a diazo sulfonyl chloride comprising 60 to 100 mole % 2,1,4 or 2,1,5 diazosulfonyl chloride, or a mixture thereof; the photosensitizer being present in the photoresist composition in an amount sufficient to uniformly photosensitize the photoresist composition; and
(b) a water insoluble, aqueous alkali soluble novolak resin, the novolak resin being present in the photoresist composition in an amount sufficient to form a substantially uniform photoresist composition.

2. The composition of claim 1 further comprising one or more solvents.

3. The composition of claim 2 wherein said solvent comprises propylene glycol monomethyl ether acetate.

4. The composition of claim 1 wherein (a) is present in an amount of from 1 to 35 weight percent and (b) is present in an amount from 65 to 95 weight percent, based on the non-solvent components of the composition.

5. The composition of claim 1 wherein said solvent comprises ethyl-3-ethoxypropionate.

6. The composition of claim 1 further comprising one or more additives selected from the group consisting of colorants, leveling agents, anti-striation agents, plasticizers, adhesion promoters, speed enhancers and surfactants.

7. A photosensitive element comprising a substrate and the dried composition of claim 1 coated on said substrate.

8. The element of claim 7 wherein the substrate is selected from the group consisting of silicon, aluminum, polymeric resins, silicon dioxide doped silicon dioxide, gallium arsenide, Group III/V compounds, silicon nitride, tantalum, copper, polysilicon, ceramics and aluminum/copper mixtures.

9. The element of claim 7 wherein the substrate has an adhesion promoted surface.

10. The element of claim 7 wherein the composition further comprises one or more components selected from the group consisting of non-aromatic colorants, dyes, anti-striation agents, leveling agents, plasticizers, adhesion promoters, speed enhancers and surfactants.

11. The element of claim 7 wherein (a) is present in an amount of from 1 to 35 weight percent and (b) is present in an amount of from 65 to 99 weight percent, based on the non-solvent components of the composition.

12. A method for producing a photoresist image on a substrate, which comprises coating a substrate with a positive working photosensitive composition which composition comprises in admixture:
(a) a photosensitive component comprising a diazo ester having the following structure: 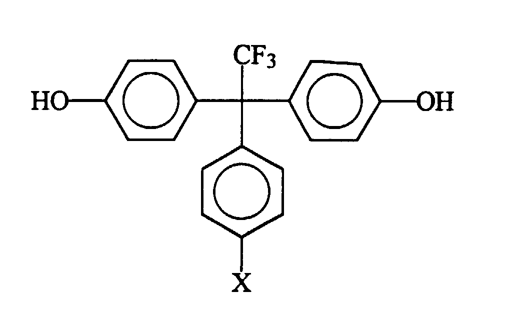 X = Cl, Br, I, OH, OR, COOR, COOAr(OH)ₙ,COAr(OH)ₙ, COR, R, Ar(OH)ₙ R = C₁-C₈ alkyl, n = 0 to 5, Ar = Phenyl
as the backbone, where the diazo ester is a compound containing at least one hydroxy group on the phenyl ring which has been esterified with a diazo sulfonyl chloride comprising 60 to 100 mole % 2,1,4 or 2,1,5 diazo sulfonyl chloride or a mixture thereof, said photosensitive component being present in the photoresist composition in an amount sufficient to uniformly photosensitize the photoresist composition; and
(b) a water insoluble, aqueous alkali soluble novolak resin; said novolak resin being present in the photoresist composition in an amount sufficient to form a substantially uniform photoresist composition and a solvent composition; and heat treating said coated substrate until substantially all of said solvent composition is removed; imagewise exposing said photosensitive composition to actinic radiation; and removing the imagewise exposed areas of said composition with an aqueous alkaline developer.

13. The method of claim 12 further comprising heating said coated substrate from a temperature of from 90°C to 150°C for from 30 seconds to 180 seconds on a hot plate or from 15 minutes to 40 minutes in an oven, after the exposure step but before the removing step.

14. The method of claim 12 further comprising heating said coated substrate at a temperature of from 90°C to 150°C for 30 second to 180 seconds on a hot plate or for from 15 minutes to 40 minutes in an oven, after the removing step.

15. The method of claim 12 wherein said substrate comprises one or more components selected from the group consisting of silicon, aluminum, polymeric resins, silicon dioxide, doped silicon dioxide, silicon nitride, tantalum, copper, polysilicon, ceramics, aluminum/copper mixtures, gallium arsenide and Group III/V compounds.

16. The method of claim 12 wherein the exposure step is conducted with actinic, x-ray or ion beam radiation.

17. The method of claim 12 wherein the exposure step is conducted with ultraviolet radiation having a wavelength of 365 nm.

18. The method of claim 12 wherein the developing step is conducted with sodium hydroxide, potassium hydroxide or tetramethyl ammonium hydroxide.

19. The method of claim 12 wherein the composition further comprises one or more components selected from the group consisting of non-aromatic colorants, dyes, anti-striation agents, leveling agents, plasticizers, adhesion promoters, speed enhancers, and surfactants.

20. The method of claim 12 wherein (a) is present in an amount of from 1 to 35 weight percent and (b) is present in an amount of from 65 to 99 weight percent, based on the non-solvent parts of the composition.

21. The method of claim 12 wherein the solvent composition comprises one or more solvents.

22. The method of claim 12 wherein the solvent comprises propylene glycol monomethyl ether acetate.

23. The method of claim 12 wherein the solvent comprises ethyl-3-ethoxy propionate.

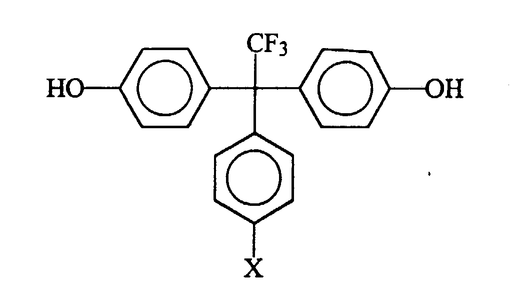

24. A photosensitizer comprising a diazo ester having the following structure:
X = Cl, Br, I, OH, OR, COOR, COOAr(OH)ₙ,COAr(OH)ₙ, COR, R, Ar(OH)ₙ
R = C₁-C₈ alkyl, n = 0 to 5, Ar = Phenyl
where the diazo ester is a compound wherein at least one hydroxy group on the phenyl ring has been esterified with diazo sulfonyl chloride comprising of 60 to 100 mole % 2,1,4- or 2,1,5- diazosulfonyl chloride, or a mixture thereof.

## Patentansprüche

1. Positiv arbeitende Photoresistzubereitung umfassend ein Gemisch von:
(a) Photosensibilisator mit einem Diazoester folgender Struktur 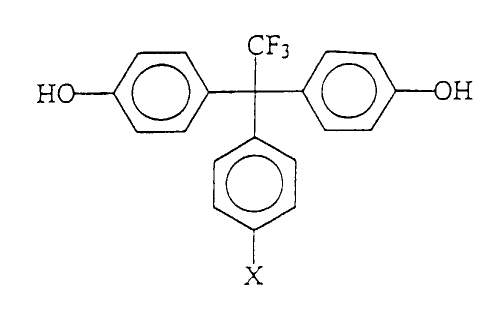 X = Cl, Br, I, OH, OR, COOR, COOAr(OH)ₙ, COAr(OH)ₙ, COR, R, Ar(OH)ₙ; R = C₁-C₈ Alkyl, n = 0 to 5; Ar = Phenyl
als Rückgrat, wobei der Diazoester eine Verbindung ist, bei der mindestens eine Hydroxygruppe am Phenylring durch ein Diazosulfonylchlorid mit 60 bis 100 Molprozent 2,1,4- oder 2,1,5-Diazosulfonylchlorid oder einem Gemisch dieser beiden Substanzen verestert ist und wobei der Photosensibilisator in der Photoresistzubereitung in ausreichender Menge vorhanden ist, um eine einheitliche Photosensibilisierung der Photoresistzubereitung herbeizuführen, und
(b) einem wasserunlöslichen, in wäßrigem Alkali löslichen Novolakharz, wobei dieses Harz in der Photoresistzubereitung in ausreichender Menge vorhanden ist, um eine weitgehend einheitliche Photoresistzubereitung zu bilden.

2. Zubereitung gemäß Anspruch 1 mit einem oder mehreren Lösungsmitteln.

3. Zubereitung gemäß Anspruch 2, wobei das genannte Lösungsmittel Propylenglycolmonomethyletheracetat enthält.

4. Zubereitung gemäß Anspruch 1, wobei (a) in einer Menge von 1 bis 35 Gewichtsprozent und (b) in einer Menge von 65 bis 95 Gewichtsprozent vorliegt, bezogen auf die Bestandteile der Zubereitung, die keine Lösungsmittel sind.

5. Zubereitung gemäß Anspruch 1, wobei das genannte Lösungsmittel Ethyl-3-ethoxypropionat enthält.

6. Zubereitung gemäß Anspruch 1, die ferner ein oder mehrere aus der Gruppe der Farbstoffe, Egalisiermittel, Hemmstoffe gegen Schlierenbildung, Weichmacher, Haftvermittler, Reaktionsbeschleuniger und Tenside gewählte Additive enthält.

7. Lichtempfindlicher Bestandteil aus einem Substrat und der getrockneten, auf dieses Substrat aufgebrachten Zubereitung gemäß Anspruch 1.

8. Bestandteil gemäß Anspruch 7, wobei das Substrat aus der Gruppe Silicium, Aluminium, polymere Harze, Siliciumdioxid. dotiertes Siliciumdioxid, Galliumarsenid, Gruppe-III/V-Verbindungen, Siliciumnitrid, Tantal, Kupfer, Polysilicium, Keramik und Aluminium-Kupfer-Gemischen gewählt wird.

9. Bestandteil gemäß Anspruch 7, wobei das Substrat eine mit einem Adhäsionsvermittler behandelte Oberfläche besitzt.

10. Bestandteil gemäß Anspruch 7, wobei die Zubereitung ferner mindestens einen aus der Gruppe der nichtaromatischen Farbstoffe, Färbemittel, Substanzen gegen Schlierenbildung, Egalisiermittel, Weichmacher, Adhäsionsvermittler, Reaktionsbeschleuniger und Tenside gewählten Bestandteil enthält.

11. Bestandteil gemäß Anspruch 7, wobei (a) in einer Menge von 1 bis 35 Gewichtsprozent und (b) in einer Menge von 65 bis 99 Gewichtsprozent vorliegt, bezogen auf die Bestandteile der Zubereitung, die keine Lösungsmittel sind

12. Verfahren für die Herstellung eines Photoresistbildes auf einem Substrat, bei dem ein Substrat mit einer positiv arbeitenden, lichtempfindlichen Zubereitung beschichtet wird, wobei die genannte Zubereitung folgendes Gemisch umfaßt:
(a) einen lichtempfindlichen Bestandteil, der einen Diazoester der folgenden Struktur enthält 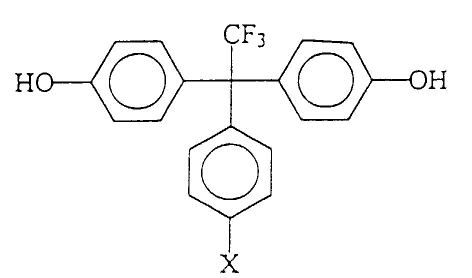 X = Cl, Br, I, OH, OR, COOR, COOAr(OH)ₙ, COAr(OH)ₙ, COR, R, Ar(OH)ₙ; R = C₁-C₈ Alkyl, n = 0-5; Ar = Phenyl
als Rückgrat, wobei der Diazoester eine Verbindung ist, bei der mindestens eine Hydroxygruppe am Phenylring durch ein Diazosulfonylchlorid aus 60 - 100 Molprozent 2,1,4- oder 2,1,5-Diazosulfonylchlorid oder einem Gemisch dieser beiden Substanzen verestert ist und wobei der Photosensibilisator in der Photoresistzubereitung in ausreichender Menge vorhanden ist, um eine einheitliche Photosensibilisierung der Photoresistzubereitung herbeizuführen, und
(b) einem wasserunlöslichen, in wäßrigem Alkali löslichen Novolakharz, wobei dieses Harz in der Photoresistzubereitung in ausreichender Menge vorhanden ist, um eine weitgehend einheitliche Photoresistzubereitung und eine Lösungsmittelzubereitung zu bilden; Wärmebehandlung des genannten beschichteten Substrats bis zur Entfernung von praktisch der gesamten Lösungsmittelzubereitung; bildgemäße Einwirkung von aktinischer Strahlung auf die genannte lichtempfindliche Zubereitung und Entfernung der bildgemäß belichteten Bereiche der genannten Zubereitung mit einem wäßrig-alkalischen Entwickler.

13. Verfahren gemäß Anspruch 12, bei dem das genannte beschichtete Substrat ferner nach der Belichtung, aber noch vor dem Entfernen der belichteten Bereiche auf einer Heizplatte 30 bis 180 Sekunden lang oder im Trockenofen 15 bis 40 Minuten lang auf eine Temperatur von 90 bis 150°C erwärmt wird.

14. Verfahren gemäß Anspruch 12, bei dem das genannte beschichtete Substrat ferner nach dem Entfernen der belichteten Bereiche auf einer Heizplatte 30 bis 180 Sekunden lang oder im Trockenofen 15 bis 40 Minuten lang auf eine Temperatur von 90 bis 150°C erwärmt wird.

15. Verfahren gemäß Anspruch 12, wobei das genannte Substrat mindestens einen aus der Gruppe Silicium, Aluminium, polymere Harze, Siliciumdioxid, dotiertes Siliciumdioxid, Siliciumnitrid, Tantal, Kupfer, Polysilicium, Keramik, Aluminium-Kupfer-Gemischen, Galliumarsenid und Gruppe-III/V-Verbindungen gewählten Bestandteil enthält.

16. Verfahren gemäß Anspruch 12, wobei die Bestrahlung mit aktinischen, Röntgen- oder Ionenstrahlen erfolgt.

17. Verfahren gemäß Anspruch 12, wobei die Bestrahlung mit UV-Strahlung der Wellenlänge 365 nm erfolgt.

18. Verfahren gemäß Anspruch 12, wobei der Entwicklungsschritt mit Natriumhydroxid, Kaliumhydroxid oder Tetramethylammoniumhydroxid durchgeführt wird.

19. Verfahren gemäß Anspruch 12, wobei die Zubereitung ferner mindestens einen aus der Gruppe der nichtaromatischen Farbstoffe, Färbemittel, Substanzen gegen Schlierenbildung, Egalisiermittel, Weichmacher, Adhäsionsvermittler, Reaktionsbeschleuniger und Tenside gewählten Bestandteil enthält.

20. Verfahren gemäß Anspruch 12, wobei (a) in einer Menge von 1 bis 35 Gewichtsprozent und (b) in einer Menge von 65 bis 99 Gewichtsprozent vorliegt, bezogen auf die Bestandteile der Zubereitung, die keine Lösungsmittel sind.

21. Verfahren gemäß Anspruch 12, wobei die Lösungsmittelzubereitung ein oder mehr als ein Lösungsmittel enthält.

22. Verfahren gemäß Anspruch 12, wobei das Lösungsmittel Propylenglycolmonomethyletheracetat enthält.

23. Verfahren gemäß Anspruch 12, wobei das Lösungsmittel Ethyl-3-ethoxypropionat enthält.

24. Photosensibilisator, der einen Diazoester folgender Struktur enthält: 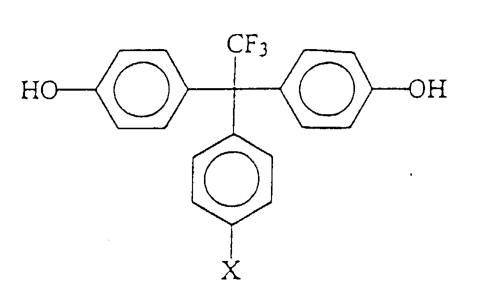 X = Cl, Br, I, OH, OR, COOR, COOAr(OH)ₙ, COAr(OH)ₙ, COR, R, Ar(OH)ₙ; R = C₁-C₈ Alkyl, n = 0 bis 5; Ar = Phenyl
wobei der Diazoester eine Verbindung ist, bei der mindestens eine Hydroxygruppe am Phenylring durch ein Diazosulfonylchlorid mit 60 bis 100 Molprozent 2,1,4- oder 2,1,5-Diazosulfonylchlorid oder einem Gemisch dieser beiden Substanzen verestert ist.

## Revendications

1. Composition de photorésist positif comprenant un mélange de :
(a) un photosensibilisant comprenant un ester diazoïque ayant la structure suivante : 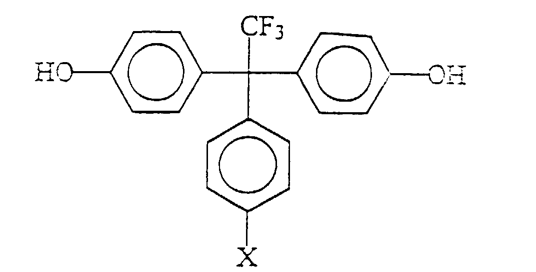 X = Cl, Br, I, OH, OR, COOR, COOAr(OH)ₙ, COAr(OH)ₙ, COR, R, Ar(OH)ₙ, R = alkyle en C₁ à C₈, n = 0 à 5, Ar = phényle
en tant que squelette, où l'ester diazoïque est un composé dans lequel au moins un groupe hydroxyle sur le noyau phényle a été estérifié avec un chlorure de diazosulfonyle comprenant du chlorure de 2,1,4- ou de 2,1,5-diazosulfonyle, ou un mélange de ceux-ci à raison de 60 à 100% en moles, le photosensibilisant étant présent dans la composition de photorésist en quantité suffisante pour photosensibiliser uniformément la composition de photorésist ; et
(b) une résine novolaque soluble dans les bases aqueuses et insoluble dans l'eau, la résine novolaque étant présente dans la composition de photorésist en quantité suffisante pour former une composition de photorésist essentiellement uniforme.

2. Composition selon la revendication 1, comprenant de plus un ou plusieurs solvants.

3. Composition selon la revendication 2, dans laquelle ledit solvant comprend l'acétate de l'éther méthylique du propylèneglycol.

4. Composition selon la revendication 1, dans laquelle (a) est présent en une quantité de 1 à 35% de poids et (b) est présente en une quantité de 65 à 95% de poids par rapport aux composants non solvants de la composition.

5. Composition selon la revendication 1, dans laquelle ledit solvant comprend le 3-éthoxypropionate d'éthyle.

6. Composition selon la revendication 1, comprenant de plus un ou plusieurs additifs choisis dans le groupe constitué par les colorants, les agents de nivelage, les agents anti-striation, les plastifiants, les promoteurs d'adhérence, les agents améliorant la sensibilité et les agents tensio-actifs.

7. Elément photosensible comprenant un substrat et la composition séchée selon la revendication 1 déposée sur ledit substrat.

8. Elément selon la revendication 7, dans lequel le substrat est choisi dans le groupe constitué par le silicium, l'aluminium, les résines polymères, le dioxyde de silicium, le dioxyde de silicium dopé, l'arséniure de gallium, les composés du Groupe III/V, le nitrure de silicium, le tantale, le cuivre, le polysilicium, la céramique et les mélanges aluminium/cuivre.

9. Elément selon la revendication 7, dans lequel le substrat possède une surface favorisant l'adhérence.

10. Elément selon la revendication 7, dans lequel la composition comprend de plus un ou plusieurs composants choisis dans le groupe constitué par les colorants non aromatiques, les colorants, les agents anti-striation, les agents de nivelage, les plastifiants, les promoteurs d'adhérence, les agents améliorant la sensibilité et les agents tensio-actifs.

11. Elément selon la revendication 7, dans lequel (a) est présent en une quantité de 1 à 35% en poids et (b) est présente en une quantité de 65 à 99% en poids, par rapport aux composants non solvants de la composition.

12. Procédé pour produire une image de photorésist sur un substrat, consistant à revêtir un substrat au moyen d'une composition de photorésist agissant en positif, laquelle composition comprend, sous forme de mélange :
a) un composant photosensible comprenant un ester diazoïque ayant la structure suivante : 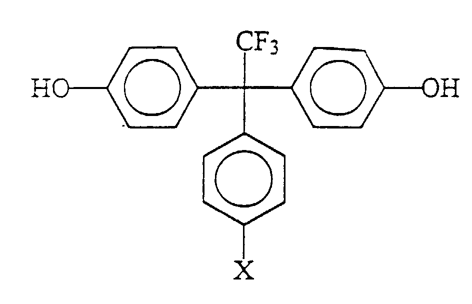 X = Cl, Br, I, OH, OR, COOR, COOAr(OH)ₙ, COAr(OH)ₙ, COR, R, Ar(OH)ₙ
R = alkyle en C₁ à C₈, n = 0 à 5, Ar = phényle
en tant que squelette, dans lequel l'ester diazoïque est un composé comprenant au moins un groupe hydroxyle sur le noyau phényle qui a été estérifié avec un chlorure de diazosulfonyle comprenant du chlorure de 2,1,4- ou de 2,1,5-diazosulfonyle, ou un mélange de ceux-ci, à raison de 60 à 100% en moles, ledit composant photosensible étant présent dans la composition de photorésist en quantité suffisante pour photosensibiliser uniformément la composition de photorésist ; et
(b) une résine novolaque soluble dans les bases aqueuses et insoluble dans l'eau, ladite résine novolaque étant présente dans la composition de photorésist en quantité suffisante pour former une composition de photorésist essentiellement uniforme et une composition de solvant ; et consistant à traiter thermiquement ledit substrat revêtu jusqu'à ce que pour l'essentiel toute ladite composition de solvant ait disparu ; à exposer selon une image ladite composition photosensible à un rayonnement actinique ; et à éliminer les parties exposées selon une image de ladite composition avec un révélateur basique aqueux.

13. Procédé selon la revendication 12, consistant de plus à chauffer ledit substrat revêtu à une température de 90°C à 150°C pendant 30 à 180 secondes sur une plaque chaude ou 15 à 40 minutes dans un four, après l'étape d'exposition mais avant l'étape d'élimination.

14. Procédé selon la revendication 12, consistant de plus à chauffer ledit substrat revêtu à une température de 90°C à 150°C pendant 30 à 180 secondes sur une plaque chaude ou pendant 15 à 40 minutes dans un four, après l'étape d'élimination.

15. Procédé selon la revendication 12, dans lequel ledit substrat comprend un ou plusieurs composants choisis dans le groupe constitué par le silicium , l'aluminium, les résines polymères, le dioxyde de silicium, le dioxyde de silicium dopé, le nitrure de silicium, le tantale, le cuivre, de polysilicium, la céramique, les mélanges aluminium/cuivre, l'arséniure de gallium et les composés du Groupe III/V.

16. Procédé selon la revendication 12, dans lequel l'étape d'exposition se réalise à l'aide d'un rayonnement actinique, d'un rayonnement x ou d'un faisceau d'ions.

17. Procédé selon la revendication 12, dans lequel l'étape d'exposition se réalise à l'aide d'un rayonnement ultraviolet ayant une longueur d'onde de 365 nm.

18. Procédé selon la revendication 12, dans lequel l'étape de développement se réalise avec de l'hydroxyde de sodium, de l'hydroxyde de potassium ou de l'hydroxyde de tétraméthylammonium.

19. Procédé selon la revendication 12, dans lequel la composition comprend de plus un ou plusieurs composants choisis dans le groupe constitué par les colorants non aromatiques, les colorants, les agents anti-striation, les agents de nivelage, les plastifiants, les promoteurs d'adhérence, les agents améliorant la sensibilité, et les agents tensio-actifs.

20. Procédé selon la revendication 12, dans lequel (a) est présent en une quantité de 1 à 35% de poids et (b) est présente en une quantité de 65 à 99% de poids, par rapport aux parties non solvant de la composition.

21. Procédé selon la revendication 12, dans lequel la composition de solvant comprend un ou plusieurs solvants.

22. Procédé selon la revendication 12, dans lequel le solvant comprend l'acétate de l'éther méthylique du propylèneglycol.

23. Procédé selon la revendication 12, dans lequel le solvant comprend le 3-éthoxypropionate d'éthyle.

24. Photosensibilisant comprenant un ester diazoïque ayant la structure suivante : 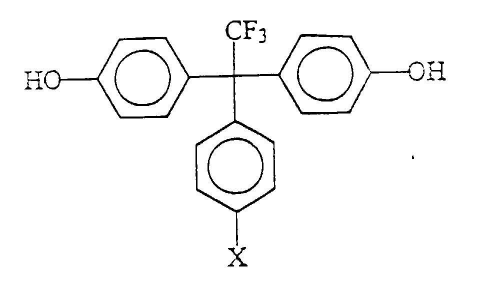 X = Cl, Br, I, OH, OR, COOR, COOAr(OH)ₙ, COAr(OH)ₙ, COR, R, Ar(OH)ₙ, R = alkyle en C₁ à C₈, n = 0 à 5, Ar = phényle
où l'ester diazoïque est un composé dans lequel au moins un groupe hydroxyle sur le noyau phényle a été estérifié avec du chlorure de diazosulfonyle comprenant du chlorure de 2,1,4- ou 2,1,5-diazosulfonyle ou un mélange de ceux-ci à raison de 60 à 100% en moles.
